# EUROPEAN PATENT APPLICATION

(11) **EP 1 903 344 A1**
(43) Date of publication of application: **26.03.2008**
(21) Application number: 07116691.2
(22) Date of filing: 18.09.2007
(51) Int. Cl.: G01R 31/28

(54) **Pushing block and a handler with the pushing block**

(30) Priority: 22.09.2006 KR 20060092269
(71) Applicant: Mirae Corporation, 330-220 Chungcheongnam-do (KR)
(72) Inventor: Ahn, Jung-ug, 330-220, Chungcheongnam-do (KR); Kim, Sun-hwal, 330-220, Chungcheongnam-do (KR); Choi, Wan-hee, 330-220, Chungcheongnam-do (KR); Hur, Jung, 330-220, Chungcheongnam-do (KR)
(74) Representative: Vetter, Ewald Otto

(57) **Abstract**

Provided is a pushing block for use in a handle and a handler equipped with the pushing block. The pushing block includes pushing pins, provided under the test tray, each pushing the latch upwards from under the test tray to enable the latch to release the packaged chip, a first plate on which the pushing pins are provided, and an assembly changing horizontal motion into vertical motion to move the first plate vertically. Positioning of the pushing block under the test tray prevents interference between the pushing block and the picker during loading and unloading and makes it convenient to take corrective action when malfunction of the picker occurs.

## Description

### BACKGROUND OF THE INVENTION

### 1. Field of the Invention

The present invention relates to a pushing block which enables a latch to hold in place or release a packaged chip in a socket of a test tray when loading or unloading the packaged chip upon and from the socket and a handler equipped with the pushing block.

### 2. Description of the Background Art

At the conclusion of a packaging process, a handler puts packaged chips through a series of environmental, electrical, and reliability tests. These tests vary in type and specifications, depending on the customer and use of the packaged devices. The tests may be performed on all of the packages in a lot or on selected samples.

The handler puts packaged chips into a test tray and supplies the test tray to a tester. The tester includes a test board with a plurality of sockets, performing an electrical test on the packaged chips. The packaged chips are inserted into the sockets of the test board for the electrical test. The handler puts the packaged chips into a test tray, i.e. a jig and inserting the packaged chips contained in a test tray into sockets of the test board. The handler sorts the packaged chips according to test results. The handler removes packaged chips from a user tray and put the removed packaged chips into sockets of the test tray. The handler transfers the test tray to the tester. (This is referred as to "a loading operation". The handler removes tested packaged chips from the sockets of the test tray and the tested packaged chips to a user tray (This is referred as to "an unloading operation")

The handler includes a plurality of pickers picking up and transferring the packaged chips in the loading and unloading operations. The picker, movably provided on a body of the handler, picks up, transfers, and places the packaged chips.

Sockets, into which the packaged chips are inserted, are arranged in rows and columns in the test tray. Each socket includes a latch holding the packaged chips in place. When the latch releases the packaged chip, the packaged chip may be removed from the socket.

The conventional picker includes a pushing pin by which the latch is pushed to release the packaged chip. The pushing pin protrudes farther than a nozzle of the picker. This enables the pushing pin to push the latch before the nozzle comes in contact with the packaged chip, when the picker is moved down to insert or pick up the packaged chip into or from the socket.

In this case, the pushing pin has to be provided to each of the pickers. This increases a size of the picker, and requires the picker to carry the pushing pin with it even when it is not moved down to insert or pick up the packaged chip into or from the socket.

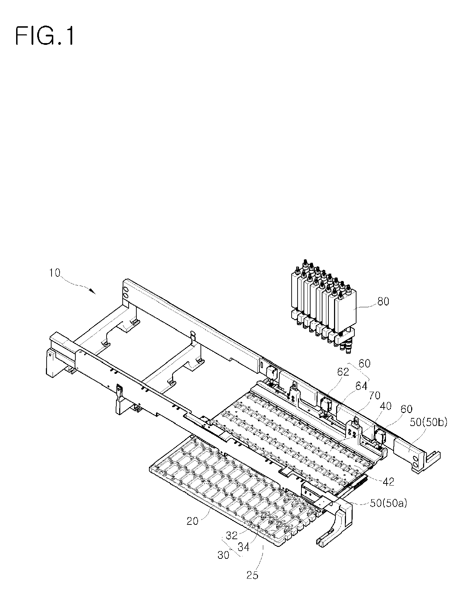

To solve such a problem, a pushing block is provided which enables the latch to release the packaged chip, as shown in FIG.1. The latch 30, including a button part 32 and a holding part 34, is provided to each of sockets of the test tray 20. The holding part 34 pushes the packaged chip inserted into the socket to hold it in place. The button part 32 is pushed by the pushing pin to enable the latch to release the packaged chip inserted into the socket.

A rotating bar (not shown) is provided between the holding part 34 and the button part 32. So, when the pushing pin pushes an upper region of the button part 34, the holding part 34 is lifted, thus releasing the packaged chip. When the pushing pin withdraws from the button part 32, the latch returns to its original position by virtue of elastic force of a torsion spring, or a coil spring, thus holding the packaged chip in place.

When the picker inserts or picks up the packaged chip into or from the socket, the pushing pin releases the latch 30. When the test tray 20 is in transit, the latch holds the packaged chip in place to prevent it from being loose or deviating or dropping from the socket.

The pushing pin 42 is provided on the pushing block 10. As shown in FIG.1, the pushing block 10 includes a pushing plate 40, on which a plurality of pushing pins is provided, and a cylinder block 60 moving up and down the pushing plate 40. Pushing pin 42 on the pushing plate 40 is as numerous as the latches on the test tray.

The pushing plate 40 is moved up and down by the cylinder block 60. The cylinder block 60 includes a cylinder 62, a connecting rod 64, and a piston. The cylinder 62 is fixably provided on a frame 50 extending over an exchanging unit. An end of the connecting rod is connected to the piston and the other to the pushing plate 40. Reciprocating motion of the piston is changed to up-and-down motion of the pushing plate 40.

The frame 50 includes a left frame 50A and a right frame 50B which are opposite to each other, in one pair.

The up-and-down motion of the pushing plate 40 enables the pushing pin 42, which is provided on the pushing plate 40, to push and release the latch of socket.

The pushing block 10 is provided over the test tray 20 on an exchanging unit. This makes it difficult to take corrective action when the picker fails to function properly, such as deviation of the packaged chip from the socket, and wrong insertion of the packaged chip into the socket. Furthermore, positioning of the pushing block 10 between the picker and the test tray causes interference between the picker and the pushing block, thus making the packaged chip deviate from the socket.

The frame 50 has to be as wide as possible to minimize the interference between the picker and the pushing block 10. The cylinder block 60 is preferably provided only on the frame 50. This requires increase in a size of the pushing plate 40, thus increasing the number of the cylinder block 60 and a driving power driving the cylinder blocks 60.

When the pushing plate 40 is too broad, the middle of the pushing plate 40 tends to bend. This causes a malfunction of the picker. For example, the pushing pin on the bent region of the pushing plate 40 fails to push the latch properly. As a result, the picker fails to pick up the packaged chip.

When the pushing plate 40 is too large, a pushing plate guide 70 has to be additionally provided to guide up-and-down motion of the pushing plate 40.

### SUMMARY OF THE INVENTION

Therefore, an object of the present invention is to provide a pushing block functioning properly without interference with a picker and a handler equipped with the pushing block.

Another object of the present invention is to provide a pushing block having a simplified structure and a handler equipped with the pushing block.

According to an aspect of the present invention, there is provided a pushing block for use in a handler, including pushing pins, provided under a test tray, each pushing a latch upwards from under the test tray to enable the latch to release a packaged chip, a first plate on which the pushing pins are provided, and an assembly changing horizontal motion into vertical motion to move the first plate vertically.

The assembly includes a cylinder base fixably provided on a body of the handler, a cylinder block including a cylinder fixably provided on a upper side of the cylinder base, and a connecting rod transferring reciprocal motion of a piston inside the cylinder, a third plate to which motion of the connecting rod is transferred, fourth plates, each having guide holes by which a direction of motion of the third plate is changed, moving rods, provided on lateral sides, moving along the guide holes, a second plate, supporting the first plate, and to which vertical motion of the third plate is transferred, and a cylinder base on which the cylinder block is fixably provided.

According to another aspect of the present invention, there is provided a handler, a test unit testing packaged chips, a loading stacker where the packaged chips are loaded for testing, an unloading stacker, provided adjacent to the loading stacker, where the tested packaged chips, after sorted, are unloaded, a test tray containing tested or not-tested packaged chips for transferring, an exchanging unit where the packaged chips tested in the test unit are unloaded from the test tray and the not-tested packaged chips are loaded upon the test tray, at least one picker moving between the loading stacker and the exchanging unit, and between the exchanging unit and the unloading stacker, to transfer the tested or not-tested packaged chips, and a pushing block, provided under the exchanging unit, including a first plate on which to provide pushing pins which release the packaged chip from the test tray, and an assembly moving the first plate vertically by changing vertical motion into horizontal motion.

Positioning of the pushing block under the test tray prevents interference between the pushing block and the picker and makes it convenient to take corrective action when malfunction of the picker occurs. Furthermore, the pushing block is made compact.

Also, the whole bottom of the first plate is supported and pushed upwards, thus enabling all the pushing pins to open the latches uniformly at the same time.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a perspective view illustrating a conventional pushing block equipped with a conventional handler;
FIG.2 is a perspective exploded view illustrating a pushing block and a test tray which are for use in a handler, according to an embodiment of the present invention and a test tray;
FIG.3 is a perspective comprehensive view illustrating the pushing block of FIG.2;
FIG.4 is a view illustrating that a moving rod arrives at an upper stopping hole and stably stays there;
FIG.5 is a view illustrating that the moving rod arrives at a lower stopping hole and stably stays there.
FIG.6 is a perspective exploded view illustrating an embodiment of a socket according to the present invention;
FIGs 7 and 8 are cross-sectional views illustrating how the socket of FIG.6 operates; and
FIG.9 is a view illustrating a handler equipped with the pushing block according to the present invention.

### DETAILED DESCRIPTION OF EXEMPLARY EMBODIMENTS

Reference will now be made in detail to the preferred embodiments of the present invention, examples of which are illustrated in the accompanying drawings.

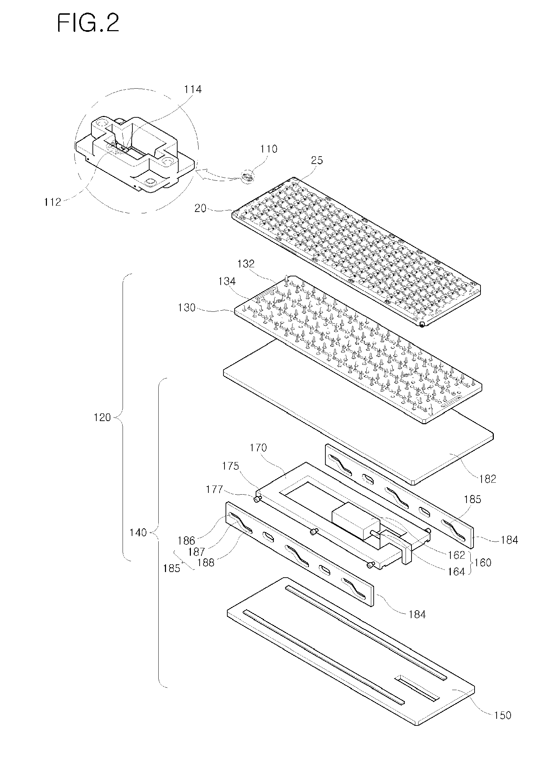

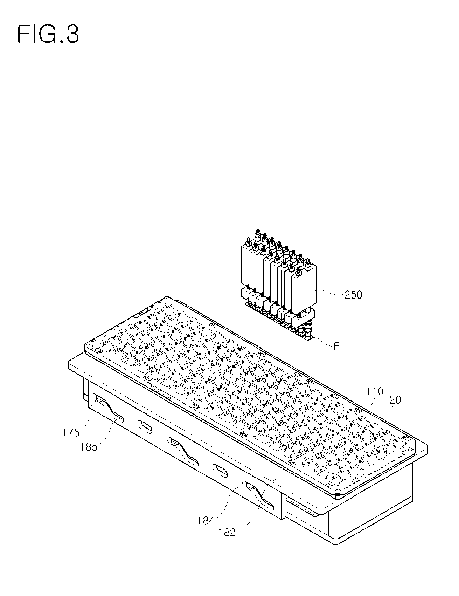

FIG.2 is a perspective exploded view illustrating a pushing block 120 and a test tray which are for use in a handler, according to an embodiment of the present invention and a test tray. FIG.3 is a perspective comprehensive view illustrating the pushing block 120 of FIG.2.

The handler inserts packaged chips into a test tray and transfers the test tray containing the packaged chips to a tester. The handler unloads tested packaged chips from sockets of the test tray.

As shown in FIGs 2 and 3, the pushing block 120 is provided under the test tray 20.

The test tray 20 is a jig which serves to contain the packaged chips for transfer. A plurality of sockets 110 is provided in rows and columns on the test tray 20. The socket 110 includes a latch which holds inserted packaged in place. The latch includes a holding part 114 holding the packaged chip, inserted into the socket, in place by pushing the packaged chip, and a butting part 112 releasing the holding part 114.

The holding part 114 is moved as the button part 112 is moved. When the button part 112 is moved up, the holding part 114 is moved up, thus releasing the packaged chips. A rotating rod is provided on one side of the button part 112 and the holding part 114 is provided the other side of the button part 112. The rotating rod provides an axis about which the latch rotates when the pushing pin 132 moves up the button part 112.

The pushing block 120 includes a first plate 130 on which the pushing pin 132 is provided, and an assembly 140 by which the first plate 130 is moved up and down.

The pushing pins 132 on the first plate 130 may be as numerous as the latches on the test tray. The pushing pin 132 may further include a guide pin 134 guiding motion of the first plate for the pushing pins 132 to push the latches accurately. The guide pin 134 protrudes from the first plate 130 farther than the pushing pin 132.

As a result, when the first plate 130 is moved up, the guide pin 134 is inserted into the guide hole and thus the pushing pin 132 accurately the button part 112 of the latch, before the pushing pin 132 comes in contact with the button part 112 of the latch.

When the pushing pin 132 moves up the button part 112 of the latch, the holding part 114 is also moved up, thus releasing the packaged chip. At this point, the picker picks up the packaged chip from the socket, or inserts the packaged chip into the empty socket.

The assembly 140 is provided under the first plate 130. The assembly 140 includes a second plate 182 supporting and holding the fist plate 130, a third plate 170 moving up and down the second plate 182, a cylinder block 160 transferring horizontal motion to the third plate 170, a pair of fourth plates 184 changing horizontal motion of the cylinder block 160 into vertical motion, and a cylinder base 150 on which the fourth plate is fixably provided.

The cylinder base 150 is fixably provided on the body of the handler. The two fourth plates 184 are provided upright on two edges of the cylinder base 150, respectively, opposite to each other. The cylinder base 162 is fixably provided on the cylinder base 150 between the two fourth plates 184

The third plate 170 is provided between the two fourth plates 184. The third plate 170 is a rectangular frame with the cylinder block 160 inside. The third plate 170 is connected to a piston inside the cylinder 162, with a connecting rod 164.

Reciprocating motion of the piston causes reciprocating motion of the third plate 170.

The fourth plate 184 has guide holes 185, each of which is longitudinal and inclined to a bottom of the fourth plate 184 with a predetermined angle. The horizontal motion of the third plate 170 is changed in the vertical motion of the third plate 170, using the guide holes 185 formed on the fourth plate 184.

Moving rods 175, which are inserted into the guide holes 185, are provided on both lateral sides of the third plate 170. Accordingly, when the reciprocating motion of the piston is transferred to the third plate 170, the moving rods 175 are moved up along the guide holes 185. In this way, the motion of the third plate 170 is changed from horizontally to vertically.

The moving rod 175 may further include a bearing 177. The bearing 177 facilitates sliding motion of the moving rod 175 along the guide hole 185.

The guide hole 185 may further include an upper stopping hole 186 and a lower stopping hole 188. In this case, the guide hole 185 includes the upper stopping hole 185, the lower stopping hole 188, and the inclined longitudinal hole connecting between the upper and lower stopping holes 185 and the 188.

The upper and lower stopping holes 186 and 188 serve to stop motion of the moving rod 175 along the guide hole 185. Furthermore, the upper and lower stopping holes 186 and 188 make motion of the moving rod 175 changed stably and smoothly.

The upper and lower stopping holes 186 and 188 may be horizontally longitudinal. This makes it possible for the moving rod 175 to slide up along the guide hole 185 in a stable manner. That is, the third plate 175, which is supported by the third plate 170, is slopingly moved up in a stable manner,

The fourth plate 184 may include a plurality of guide holes 185. Accordingly, the third plate 170 may include a plurality of moving rods 175.

The third plate 170 applies a thrust force against the second plate 182 vertically.

The second plate 182 supports the first plate 130 in a fixed manner. The second plate 182 may be wider that the first plate 130.

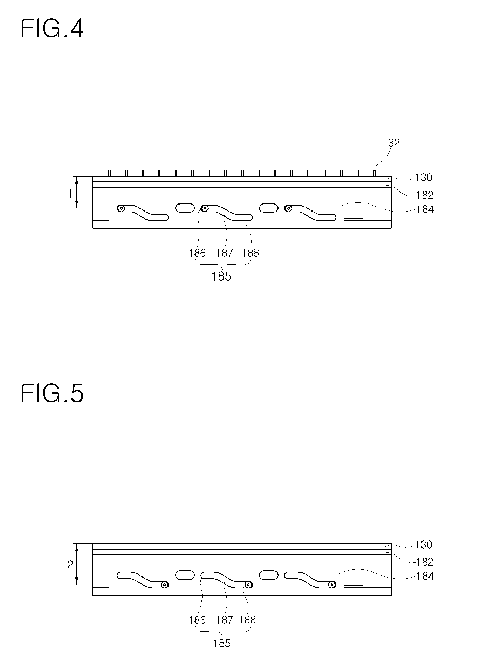

FIG.4 is a view illustrating that the moving rod 175 arrives at the upper stopping hole 186 and stably stays there. FIG.5 is a view illustrating that the moving rod 175 arrives at the lower stopping hole 188 and stably stays there. As shown in FIG.5, when the moving rod 175 slides down along the guide hole 185, a height of the first plate 130 get smaller by a vertical distance between the upper and lower stopping holes 186 and 188. This makes the pushing pin release the latch, thus closing the latch. In a reverse manner, when the moving rod 175 slides up along the guide hole 185, the height of the first hole 130 gets larger by the vertical distance between the upper and lower stopping holes 186 and 188. This makes the pushing pin push the latch, thus opening the latch.

According to the present invention, there exists no interference between the picker and the pushing block because the pushing block is positioned under the test tray. This prevent a malfunction of the picker

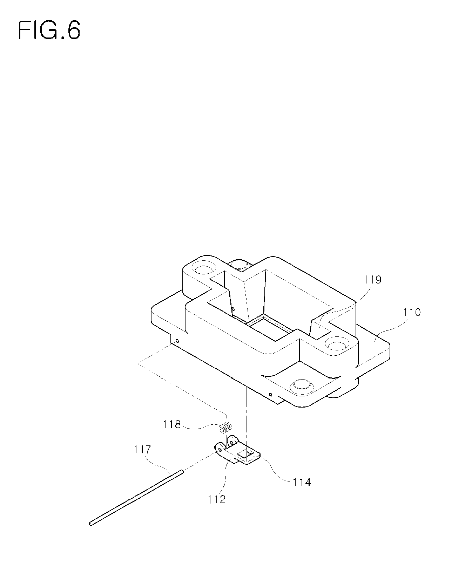

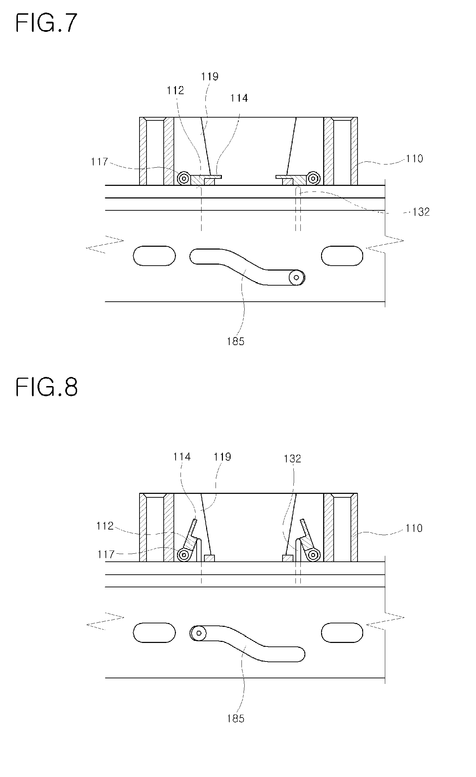

FIG.6 is a perspective exploded view illustrating an embodiment of a socket 110 according to the present invention. FIGs 7 and 8 are cross-sectional views illustrating how the socket 110 of FIG.6 operates. As shown in FIGs 6 through 8, the socket 110 includes a latch having a button part 110 and a holding part 114, a rotating rod 117 providing an axis about which the latch rotates, and a coil spring 118 returning the latch to its original position. The coil spring 118 makes the holding part 114 push the packaged chip inserted into the socket, when a predetermined amount of force isn't applied to the button part 112.

As shown in FIG.6, the button part 112 and the holding part 114 are connected to the socket 110, with the rotating rod 117. The button part 112 and the holding part 114 are rotable about the axis of the rotating rod 117 with respect to the socket. The rotating rod 117 is positioned inside the rotating rod 117, to return the holding part 114 to its original position. As shown in FIG.7, when the latch remains closed by an elastic force of the coil spring, a groove 119 of the socket isn't allowed to receive the packaged chip. As shown in FIG.8, when the latch remains opened by a thrust force of pushing pin 132, the groove 119 of the socket is allowed to receive the packaged chip. When the pushing pin 132 withdraws from the latch, the latch is closed by the elastic force of the coil spring.

The operating mechanism of the latch having the button part 112 and the holding part 114 according to the present invention is not limited to the structures of the latches shown in FIGs 6 through 8. The button part 112 and the holding part 114 as one body, may be balanced in the middle, so that the button part 112 goes up and the holding part goes down, and vice versa.

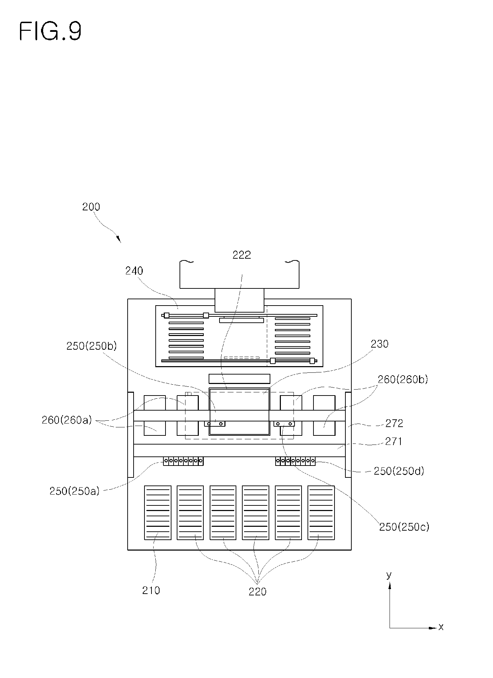

FIG.9 is a view illustrating a handler equipped with a pushing block according to the present invention. The handler according to an embodiment of the present invention includes a loading stacker 210, an unloading stacker 220, a test unit 240, pickers 250, and the pushing block provided under an exchanging unit.

The loading stacker 210 is provided in the front. User trays, each of which contains not-tested packaged chips, are placed on the loading stacker 210.

The unloading stacker 220 is provided adjacent to the loading stacker 210. Tested packaged chips, after sorted according to grades, are contained in their assigned user trays on the unloading stacker 220.

The packaged chips in the user tray are contained in a test tray 222. The test tray 222 containing the packaged chips is transferred to the loading stacker 220.

The handler may further include the exchanging unit 230. The exchanging unit 230 is an area where the not-tested packaged chips are loaded into the test tray, or the tested packaged chips are unloaded from the test tray. The buffer unit 260 is provided between the loading stacker 210 or the unloading stacker 220 and the exchanging unit 230. The buffer unit 260 temporarily receives the packaged chips transferred by the head assembly. The buffer unit includes a plate. The buffer units 260 may be provided next to both sides of the exchanging unit 230 which is provided in the middle of the main body of the handler. That is, the buffer unit 260 may include a loading buffer unit 260A and an unloading buffer unit 260B. In this case, the exchanging unit 230 is provided between the loading and unloading buffer units 260A and 260B. The buffer unit 260 may include two or more plates movable in an Y-axis direction. The picker 250, as shown in FIG.9, includes a first loading picker 250A moving between the loading stacker 210 and loading buffer unit 260A, a second loading picker 250B moving between the loading buffer unit 260A and the exchanging unit 230, a first unloading picker 250D moving between the unloading stacker 220 and the unloading buffer unit 260B, and a second unloading picker 250C moving between the exchanging unit 230 and the unloading buffer unit 260B. The pickers are movably provided to an X-axis and Y-axis gantry. The first loading picker 250A and the first unloading picker 250D may be movable in an X-axis or Y-axis direction, and the second loading picker 250B and the second unloading picker 250C may be movable in the X-axis direction.

The test unit 240 is provided in the rear. The test unit 240 includes a heating-up chamber where the packaged chips are heated up, a test chamber where the packaged chips are tested, and a cooling-down chamber where the packaged chips are cooled down. The test tray containing the packaged chips goes through the heating-up chamber, the test chamber, and the cooling-down chamber, in the preceding order.

The pushing block according to the present invention is provided under the exchanging unit. The pushing block is moved up to open the latch of the socket provided on the test tray, in order for the packaged chip to be inserted into or removed from the socket, when the test tray containing the packaged chips waits in the exchanging unit, to load or unload the packaged chip upon or from the test tray. The pushing block is moved down to close the latch of the socket provided to the test tray, in order for the packaged chip to be held in place, while the test tray is transferred to the test unit. The operation and structure of the pushing block is the same as above described.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalents of such metes and bounds are therefore intended to be embraced by the appended claims.

## Claims

1. A pushing block for use in a handler comprising a test tray, sockets arranged in rows and columns on the test tray, containing packaged chips and latches holding the packaged chips in the sockets in place, the pushing block comprising:
pushing pins, provided under the test tray, each pushing the latch upwards from under the test tray to enable the latch to release the packaged chip;
a first plate on which the pushing pins are provided, and
an assembly changing horizontal motion into vertical motion to move the first plate vertically.

2. The pushing block for use in the handler, according to claim 1 wherein the assembly comprises:
a cylinder base fixably provided on a body of the handler;
a cylinder block including a cylinder fixably provided on a upper side of the cylinder base, and a connecting rod transferring reciprocal motion of a piston inside the cylinder;
a third plate to which motion of the connecting rod is transferred;
fourth plates, each having guide holes by which a direction of motion of the third plate is changed;
moving rods, provided on lateral sides, moving along the guide holes;
a second plate, supporting the first plate, and to which vertical motion of the third plate is transferred; and
a cylinder base on which the cylinder block is fixably provided.

3. The pushing block for use in the handler, according to claim 2, wherein a bearing moving along the guide hole is further provided on one end of the moving rod.

4. The pushing block for use in the handler, according to claim 3, wherein the guide hole is longitudinal and inclined to a bottom of the fourth plate with a predetermined angle.

5. The pushing block for use in the handler, according to claim 4, wherein an upper stopping hole and a lower stopping hole are further formed on an upper end of the guide hole and an lower end of the guide hole, respectively.

6. The pushing block for use in the handler, according to claim 2, wherein two fourth plates, as one pair, are provided on both edges of the third plates, opposite to each other.

7. The pushing block for use in the handler, according to claim 2, wherein the first plate further comprises guide pins which are inserted into guide holes formed on the test tray, and properly push the latches upwards, when the second plate is moved up.

8. The pushing block for use in the handler, according to claim 6, wherein the cylinder block is provided between the pair of the fourth plates.

9. A handler comprises:
a test unit testing packaged chips;
a loading stacker where the packaged chips are loaded for testing;
an unloading stacker, provided adjacent to the loading stacker, where the tested packaged chips, after sorted, are unloaded;
a test tray containing tested or not-tested packaged chips for transferring;
an exchanging unit where the packaged chips tested in the test unit are unloaded from the test tray and the not-tested packaged chips are loaded upon the test tray;
at least one picker moving between the loading stacker and the exchanging unit, and between the exchanging unit and the unloading stacker, to transfer the tested or not-tested packaged chips; and
a pushing block, provided under the exchanging unit, including a first plate on which to provide pushing pins which release the packaged chip from the test tray; and an assembly moving the first plate vertically by changing vertical motion into horizontal motion.

10. The handler according to claim 9, wherein the test tray comprises a plurality of sockets into which the packaged chips are inserted and latches which are provided to hold the packaged chips in place, and wherein the pushing pin pushes the latches upwards from under the test tray to enable the latches to release the packaged chips.

11. The handler according to claim 9, wherein the assembly comprises:
a cylinder base fixably provided on a body of the handler;
a cylinder block including a cylinder fixably provided on a upper side of the cylinder base, and a connecting rod transferring reciprocal motion of a piston inside the cylinder;
a third plate to which motion of the connecting rod is transferred;
fourth plates, each having guide holes by which a direction of motion of the third plate is changed;
moving rods, provided on lateral sides, moving along the guide holes;
a second plate, supporting the first plate, and to which vertical motion of the third plate is transferred; and
a cylinder base on which the cylinder block is fixably provided.

12. The handler according to claim 11, wherein a bearing moving along the guide hole is further provided on one end of the moving rod.

13. The handler according to claim 11, wherein the guide hole is longitudinal and inclined to a bottom of the fourth plate with a predetermined angle.

14. The handler according to claim 13, wherein an upper stopping hole and a lower stopping hole are further formed on an upper end of the guide hole and an lower end of the guide hole, respectively.

15. The handler according to claim 11, wherein two fourth plates, as one pair, are provided on both edges of the third plates, opposite to each other.

16. The handler according to claim 11, wherein the first plate further comprises guide pins which are inserted into guide holes formed on the test tray, and properly push the latches upwards, when the second plate is moved up.

17. The handler according to claim 15, wherein the cylinder block is provided between the pair of the fourth plates.

## Amended claims

### Amended claims in accordance with Rule 137(2) EPC.

**1.** A pushing block for use in a handler comprising a test tray, sockets arranged in rows and columns on the test tray, containing packaged chips and latches holding the packaged chips in the sockets in place, the pushing block comprising:
pushing pins, provided under the test tray, each pushing the latch upwards from under the test tray to enable the latch to release the packaged chip;
a first plate on which the pushing pins are provided, and
an assembly changing horizontal motion into vertical motion to move the first plate vertically.

**2.** The pushing block for use in the handler, according to claim 1 wherein the assembly comprises:
a cylinder base fixably provided on a body of the handler;
a cylinder block including a cylinder fixably provided on a upper side of the cylinder base, and a connecting rod transferring reciprocal motion of a piston inside the cylinder;
a third plate to which motion of the connecting rod is transferred;
fourth plates, each having guide holes by which a direction of motion of the third plate is changed;
moving rods, provided on lateral sides, moving along the guide holes;
a second plate, supporting the first plate, and to which vertical motion of the third plate is transferred; and
a cylinder base on which the cylinder block is fixably provided.

**3.** The pushing block for use in the handler, according to claim 2, wherein a bearing moving along the guide hole is further provided on one end of the moving rod.

**4.** The pushing block for use in the handler, according to claim 3, wherein the guide hole is longitudinal and inclined to a bottom of the fourth plate with a predetermined angle.

**5.** The pushing block for use in the handler, according to claim 4, wherein an upper stopping hole and a lower stopping hole are further formed on an upper end of the guide hole and an lower end of the guide hole, respectively.

**6.** The pushing block for use in the handler, according to claim 2, wherein two fourth plates, as one pair, are provided on both edges of the third plates, opposite to each other.

**7.** The pushing block for use in the handler, according to claim 2, wherein the first plate further comprises guide pins which are inserted into guide holes formed on the test tray, and properly push the latches upwards, when the second plate is moved up.

**8.** The pushing block for use in the handler, according to claim 6, wherein the cylinder block is provided between the pair of the fourth plates.

**9.** A handler comprises:
a test unit testing packaged chips;
a loading stacker where the packaged chips are loaded for testing;
an unloading stacker, provided adjacent to the loading stacker, where the tested packaged chips, after sorted, are unloaded;
a test tray containing tested or not-tested packaged chips for transferring;
an exchanging unit where the packaged chips tested in the test unit are unloaded from the test tray and the not-tested packaged chips are loaded upon the test tray;
at least one picker moving between the loading stacker and the exchanging unit, and between the exchanging unit and the unloading stacker, to transfer the tested or not-tested packaged chips; and
a pushing block, provided under the exchanging unit, including a first plate on which to provide pushing pins which release the packaged chip from the test tray; and an assembly moving the first plate vertically by changing vertical motion into horizontal motion.

**10.** The handler according to claim 9, wherein the test tray comprises a plurality of sockets into which the packaged chips are inserted and latches which are provided to hold the packaged chips in place, and wherein the pushing pin pushes the latches upwards from under the test tray to enable the latches to release the packaged chips.

**11.** The handler according to claim 9, wherein the assembly comprises:
a cylinder base fixably provided on a body of the handler;
a cylinder block including a cylinder fixably provided on a upper side of the cylinder base, and a connecting rod transferring reciprocal motion of a piston inside the cylinder;
a third plate to which motion of the connecting rod is transferred;
fourth plates, each having guide holes by which a direction of motion of the third plate is changed;
moving rods, provided on lateral sides; moving along the guide holes;
a second plate, supporting the first plate, and to which vertical motion of the third plate is transferred; and
a cylinder base on which the cylinder block is fixably provided.

**12.** The handler according to claim 11, wherein a bearing moving along the guide hole is further provided on one end of the moving rod.

**13.** The handler according to claim 11, wherein the guide hole is longitudinal and inclined to a bottom of the fourth plate with a predetermined angle.

**14.** The handler according to claim 13, wherein an upper stopping hole and a lower stopping hole are further formed on an upper end of the guide hole and an lower end of the guide hole, respectively.

**15.** The handler according to claim 11, wherein two fourth plates, as one pair, are provided on both edges of the third plates, opposite to each other.

**16.** The handler according to claim 11, wherein the first plate further comprises guide pins which are inserted into guide holes formed on the test tray, and properly push the latches upwards, when the second plate is moved up.

**17.** The handler according to claim 15, wherein the cylinder block is provided between the pair of the fourth plates.
